# EUROPEAN PATENT SPECIFICATION

(11) **EP 2 749 159 B1**
(45) Date of publication and mention of the grant of the patent: **14.03.2018**
(21) Application number: 12875460.3
(22) Date of filing: 25.04.2012
(51) Int. Cl.: H05K 7/00, H05K 7/14, H05K 5/02

(54) **AN EJECTOR ASSEMBLY**
AUSWERFERANORDNUNG
ENSEMBLE ÉJECTEUR

(43) Date of publication of application: 02.07.2014
(73) Proprietor: Telefonaktiebolaget LM Ericsson (publ), 164 83 Stockholm (SE)
(72) Inventor: HE, Qingqing, Beijing 102209 (CN); JIN, Jin, Beijing 100102 (CN)
(74) Representative: Ericsson
(86) International application number: PCT/CN2012/074649
(87) International publication number: WO 2013/159290

(56) References cited:
- EP-A1- 1 786 252
- CN-A- 1 747 054
- CN-U- 201 557 351
- TW-U- M 414 803
- US-A- 4 564 250
- US-A- 5 793 614
- US-A1- 2002 187 668

## Description

### Field of the Invention

The present invention relates to an ejector assembly for a mounting attachment of an electrical apparatus.

### Background to the Invention

Ejectors are widely used on modules to facilitate mounting and ejecting process in modularized telecommunication system. To fasten module to sub-rack/chassis, normally screws are used in company with ejectors. To disassemble modules, screws need to be unfastened before pulling ejectors. However, a misoperation occurs as screws could not be unfastened or not fully unfastened, then the ejector would be stroked to allow the misoperation.

In some solutions, for avoiding such misoperation, protectors are added on a front panel, unless screw is unfastened, the protectors would stop the ejectors from moving forward and pulling modules out. However the protectors are provided, due to design defects of the protectors, the misoperation may also occur. When the misoperation is performed, components, e.g. the ejector, the screws, and corresponding fixture, or even sub-rack, would be broken.

EP178652 discloses a device for inserting and pulling out a plug-in module with front panel into or out of a rack. US4564250 discloses an ejection and grounding system for rack mounted plug-in modules.

### Summary of the Invention

According to an aspect of the present invention, an ejector assembly comprises: an ejector with a shape of "L", being provided to rotate around an axis; a lock element, being provided to move along a direction substantially perpendicular to a plan of the rotation of the ejector; wherein the ejector includes a cut-out portion, the lock element includes an end portion, and the end portion is provided to match with the cut-out portion, the endpoint being insertable into the cut-out portion to prevent the ejector from rotating, a first spring, provided between the ejector and the plate element, the first spring being configured to provide a force on the ejector along a direction of the ejector rotation, such that when the screw is free, the ejector ejects from the plate element by the force. A hole portion is provided on the lock element, and the hole portion is configured that the lock element is fixable by a screw going through the hole portion.

Alternatively or additionally, the ejector assembly is provided to assemble with a plate element; and a matching portion is provided on the plate element, and the lock element is provided to match with the matching portion so that the lock element is mounted on the plate element.

Alternatively or additionally, an axis hole is provided on the ejector, and the axis hole is configured that the ejector is mounted on the plate element by a shaft going through the axis hole.

Alternatively or additionally, further comprising a second spring, wherein the second spring is provided between the lock element and the plate element, and the second spring is configured to provide a force on the lock element along a direction substantially perpendicular to the plan of the rotation of the ejector.

Alternatively or additionally, a positioning portion is provided on the ejector, and a positioning mated portion is provided on the plate element, and the positioning portion and the positioning mated portion are configured that the positioning portion is matched with the positioning mated portion during the ejector is mounting on the plate element.

Alternatively or additionally, when the lock element is fixed by the screw, the ejector is embedded in the plate element.

Alternatively or additionally, an electronic module is equipped with the ejector assembly of the present invention.

Alternatively or additionally, an electrical apparatus includes one or more electronic modules, wherein said one or more electronic modules are equipped with the ejector assembly of the present invention.

An appreciation of the objectives of the present invention and a more complete understanding of its structure may be had by studying the following description of the preferred embodiment and by referring to the accompanying drawings.

### Brief Description of the Drawings

An embodiment of the present invention will now be described with reference to the accompanying drawings in which:
Figure 1 is a view of the ejector assembly according to an embodiment of the present invention, and shows respective elements of the ejector assembly with being unassembled;
Figure 2 is a view of the ejector assembly according to an embodiment of the present invention, and shows the ejector assembly with being assembled;
Figure 3 is a view of the ejector assembly according to an embodiment of the present invention, and shows the ejector assembly with being assembled;
Figure 4 is a view of an electronic module equipped with the ejector assembly of the present invention;
Figure 5 is a view of an electrical apparatus including one or more electronic modules, wherein said one or more electronic modules are equipped with the ejector assembly of the present invention.

### Detailed Description of the Drawings

While the invention is susceptible to various modifications and alternative forms, specific embodiments thereof are shown by way of example in the drawings and will herein be described in detail. It should be understood, however, that the drawings and detailed description thereto are not intended to limit the invention to the particular form disclosed, but on the contrary, the invention is to cover all modifications, equivalents and alternatives falling within the spirit and scope of the present invention as defined by the appended claims.

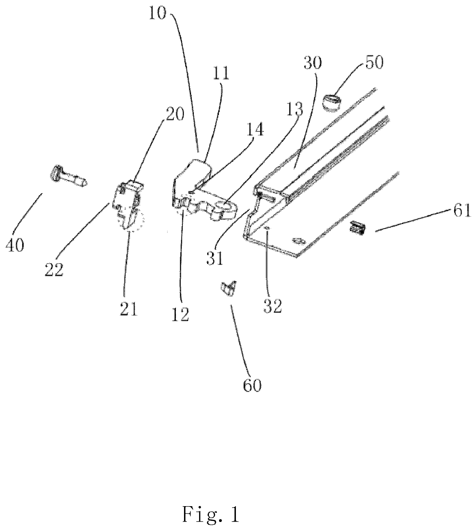

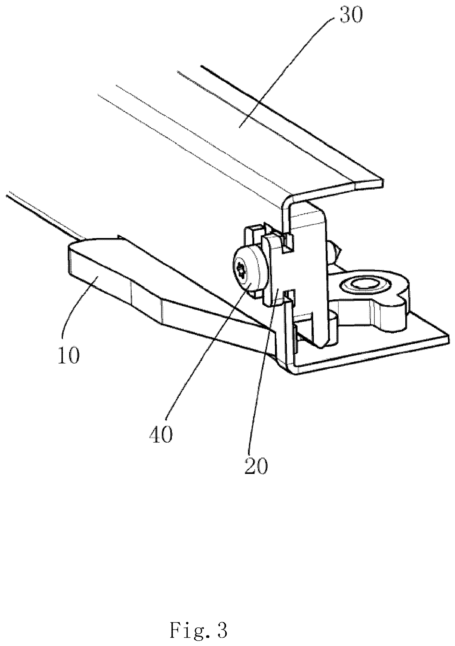

Referring to figure 1, the ejector assembly according to the present invention, comprises an ejector 10 with a shape of "L" , being provided to rotate around an axis; a lock element 20, being provided to move along a direction substantially perpendicular to a plan of the rotation of the ejector 10; wherein the ejector 10 includes a cut-out portion 12 (e.g. a groove), the lock element 12 includes an end portion 21, and the end portion 21 is provided to match with the cut-out portion 12 to prevent the ejector 10 from rotating. As shown in figure 3, the end portion of the lock element 20 is inserted into the cut-out portion of the ejector 10 so that the ejector 10 could not be rotated.

It should be noted that the shape of L does not mean the accurate L, for example, it may include a shape of arc. A person skilled in the art may provide various amendments, all of which could be deemed to be covered by the shape of L.

Referring to figure 1, in a preferred embodiment of the present invention, the ejector assembly is provided to assemble with a plate element 30 (e.g. a front panel); and a matching portion 31 is provided on the plate element 30, and the lock element 20 is provided to match with the matching portion 31 so as to mount the lock element 20 on the plate element 30.

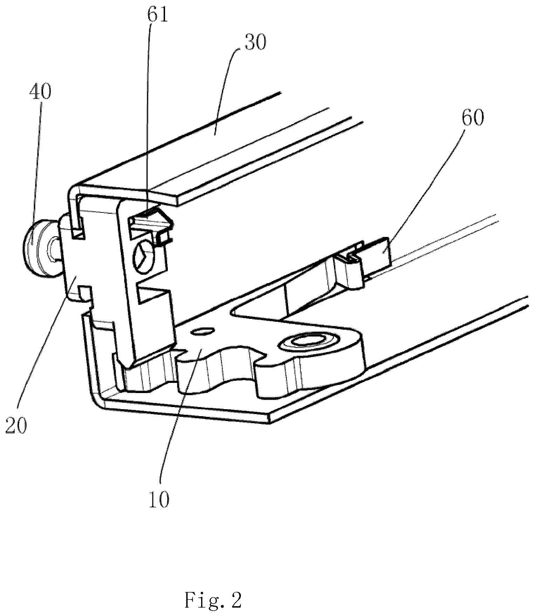

As shown in figure 2 and figure 3, the lock element 20 matches with the matching portion 31(As shown in figure 1) of the plate element 30. The structures of the lock element 20 and the matching portion of the plate element 30 shown in figures 1-3 are only example for clarity, and do not limit the scope of the invention. Those skilled in the art may provide various amendments to the structures.

Referring to figure 1, in a preferred embodiment of the present invention, a hole portion 22 is provided on the lock element 20, and the hole portion 22 is configured that the lock element 20 is fixed not to move by a screw 40 going through the hole portion 22. Those skilled in the art may provide other amendments for attaching the lock element 20 to the plate element 30 detachably.

Referring to figure 2, wherein the screw 40 is loosened, the lock element 20 may move freely, and the end portion of the lock element 20 is not inserted into the cut-out portion of the ejector 40, so that the ejector 10 is capable to rotate; referring to figure 3, wherein the screw 40 is tightened, and the end portion of the lock element 20 is inserted into the cut-out portion of the ejector 40, so that the ejector 10 does not rotate.

Referring to figure 1, in a preferred embodiment of the present invention, an axis hole 13 is provided on the ejector 10, and the axis hole 13 is configured that the ejector 10 is mounted on the plate element 30 by a shaft 50 going through the axis hole 13. Those skilled in the art may provide other amendments for mounting the ejector 10 on the plate element 30 rotatablely.

Referring to figures 1 and 2, in a preferred embodiment of the present invention, the ejector assembly further comprises a first spring 61, wherein the first spring 61 is provided between the lock element 20 and the plate element 30, and the first spring 61 is configured to provide a force on the lock element 20 along a direction substantially perpendicular to the plan of the rotation of the ejector 10. Those skilled in the art may provide other amendments for providing a resilience force between the lock element 20 and the plate element 30.

Referring to figures 1 and 2, in a preferred embodiment of the present invention, the ejector assembly further comprises a second spring 60, wherein the second spring 60 is provided between the ejector 10 and the plate element 30, and the second spring 60 is configured to provide a force on the ejector 10 along a direction of the ejector 10 rotation. Those skilled in the art may provide other amendments for providing a resilience force between the ejector 10 and the plate element 30.

Referring to figure 1, in a preferred embodiment of the present invention, a positioning portion 14 is provided on the ejector 10, and a positioning mated portion 32 is provided on the plate element 30, and the positioning portion 14 and the positioning mated portion 32 are configured that the positioning portion 14 is matched with the positioning mated portion 32 during the ejector 10 is mounting on the plate element 30

In a preferred embodiment of the present invention, the positioning portion is a depression or embossment, and the positioning mated portion is a embossment or depression corresponding to the positioning portion. Those skilled in the art may provide various amendments to the above structures.

Referring to figures 3, in the preferred embodiment of the present invention, when the lock element 20 is fixed by the screw 40, the ejector10 is embedded in the plate element 30.

Referring to figures 2, in the preferred embodiment of the present invention, when the screw 40 is free, the ejector 10 ejects from the plate element 30 by the force.

In the preferred embodiment of the present invention, when the lock element 20 is fixed by the screw 40, the ejector 10 is embedded in the plate element 30. Therefore, when the screw 40 is tightened, it is difficult to operate the ejector by user so that a misoperation is avoided again.

The ejector assembly according to embodiments of the present invention, in one aspect, provides that the end portion of the lock element is inserted into the cut-out portion of the ejector, so that the ejector could not be rotated, and thus the misoperation is avoided and the apparatus is protected. In another aspect, when the lock element is fixed by the screw, the ejector is embedded in the plate element and thus no enough room for hand or some tools. Therefore, when the screw is tightened, it is difficult to operate the ejector by user so that a misoperation is avoided again. The above two aspects provide a protection for the apparatus. The solutions of the above aspects may be applied singly, and may be combined.

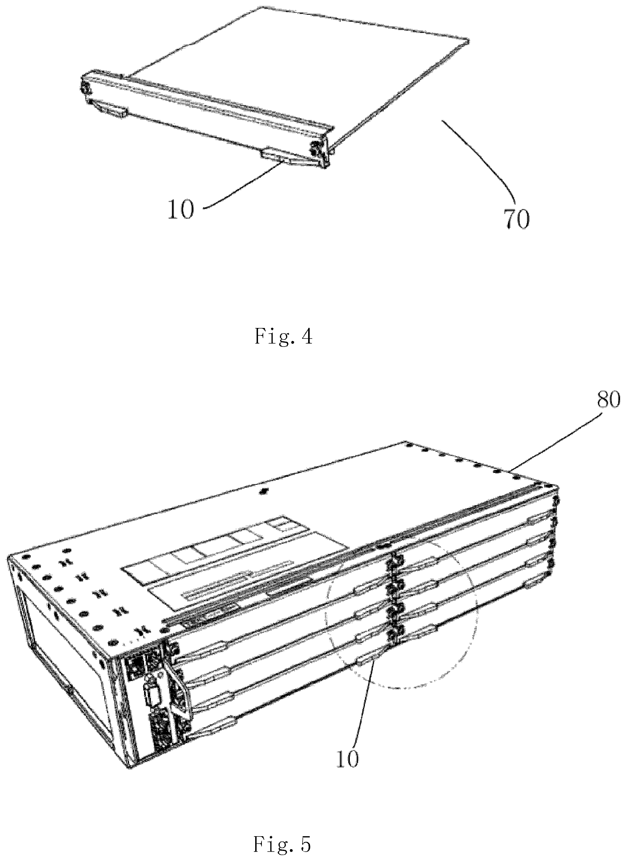

Referring to figure 4 and figure 5, as shown figure 4, an electronic module 70 (e.g. a line card) is equipped with the ejector assembly of the present invention; as shown figure 5, an electrical apparatus 80 includes one or more electronic modules 70, wherein said one or more electronic modules 70 are equipped with the ejector assembly of the present invention.

While there has been described what is believed to be the preferred embodiment of the invention, those skilled in the art will recognize that other and further modifications may be made thereto without departing from the spirit of the invention, and it is intended to claim all such embodiments that fall within the true scope of the invention.

## Claims

1. An ejector assembly for a mounting attachment of an electrical apparatus, comprising:
an ejector (10) with a shape of "L", being provided to rotate around an axis;
a lock element (20), being provided to move along a direction substantially perpendicular to a plan of the rotation of the ejector (10), wherein the ejector (10) includes a cut-out portion (12), the lock element (20) includes an end portion (21), and the end portion (21) is provided to match with the cut-out portion (12), the endpoint being insertable into the cut-out portion to prevent the ejector (10) from rotating;
**characterized in that** a hole portion (22) is provided on the lock element (20), the hole portion (22) being configured such that the lock element (20) is fixable by a screw (40) going through the hole portion (22), a first spring (60), provided between the ejector (10) and the plate element (30), the first spring (60) being configured to provide a force on the ejector (10) along a direction of the ejector (10) rotation, such that when the screw (40) is loosened it allows the lock element (20) to move freely such that the end portion (21) of the lock element (20) is not inserted into the cut-out portion of the ejector (40), the ejector (10) being capable to rotate such that the ejector (10) ejects from the plate element (30) by the force of said spring (60).

2. The ejector assembly of claim 1, wherein
the ejector assembly is provided to assemble with a plate element (30); and
a matching portion (31) is provided on the plate element (30), and the lock element (20) is provided to match with the matching portion (31) so as to mount the lock element (20) on the plate element (30).

3. The ejector assembly of claim 2, wherein
an axis hole (13) is provided on the ejector (10), and the axis hole (13) is configured that the ejector (10) is mounted on the plate element (30) by a shaft (50) going through the axis hole (13).

4. The ejector assembly of claim 2, further comprising a second spring (61), wherein
the second spring (61) is provided between the lock element (20) and the plate element (30), and the second spring (61) is configured to provide a force on the lock element (20) along a direction substantially perpendicular to the plan of the rotation of the ejector (10).

5. The ejector assembly of claim 2, wherein
a positioning portion (14) is provided on the ejector (10), and a positioning mated portion (32) is provided on the plate element (30), and the positioning portion (14) and the positioning mated portion (32) are configured that the positioning portion (14) is matched with the positioning mated portion (32) during the ejector (10) is mounting on the plate element (30).

6. The ejector assembly of claim 1, wherein
when the lock element (20) is fixed by the screw (40), the ejector(lO) is embedded in the plate element (30).

7. An electronic module equipped with the ejector assembly of any claim from 1 to 6.

8. An electrical apparatus including one or more electronic modules, wherein said one or more electronic modules are equipped with the ejector assembly of any claim from 1 to 7.

## Patentansprüche

1. Auswerferanordnung für eine Montagebefestigung einer elektrischen Vorrichtung, umfassend:
einen Auswerfer (10) mit einer Form eines "L", der bereitgestellt ist, um eine Achse zu rotieren;
ein Sperrelement (20), das bereitgestellt ist, sich entlang einer Richtung im Wesentlichen senkrecht zu einer Rotationsebene des Auswerfers (10) zu bewegen, wobei der Auswerfer (10) einen Ausschnittabschnitt (12) enthält, das Sperrelement (20) einen Endabschnitt (21) enthält und der Endabschnitt (21) bereitgestellt ist, mit dem Ausschnittabschnitt (12) übereinzustimmen, wobei der Endpunkt in den Ausschnittabschnitt einfügbar ist, um ein Rotieren des Auswerfers (10) zu verhindern;
**dadurch gekennzeichnet, dass** ein Lochabschnitt (22) auf dem Sperrelement (20) bereitgestellt ist, wobei der Lochabschnitt (22) so konfiguriert ist, dass das Sperrelement (20) durch eine Schraube (40), die durch den Lochabschnitt (22) geht, fixierbar ist, eine erste Feder (60), die zwischen dem Auswerfer (10) und dem Plattenelement (30) bereitgestellt ist, wobei die erste Feder (60) konfiguriert ist, eine Kraft auf dem Auswerfer (10) entlang einer Rotationsrichtung des Auswerfers (10) bereitzustellen, sodass es, wenn die Schraube (40) gelöst ist, möglich ist, das Sperrelement (20) frei zu bewegen, sodass der Endabschnitt (21) des Sperrelements (20) nicht in den Ausschnittabschnitt des Auswerfers (40) eingefügt ist, wobei der Auswerfer (10) imstande ist, so zu rotieren, dass der Auswerfer (10) durch die Kraft der Feder (60) vom Plattenelement (30) ausgeworfen wird.

2. Auswerferanordnung nach Anspruch 1, wobei die Auswerferanordnung bereitgestellt ist, mit einem Plattenelement (30) zusammengefügt zu werden; und
ein Übereinstimmungsabschnitt (31) auf dem Plattenelement (30) bereitgestellt ist und das Sperrelement (20) bereitgestellt ist, mit dem Übereinstimmungsabschnitt (31) übereinzustimmen, um das Sperrelement (20) auf dem Plattenelement (30) zu montieren.

3. Auswerferanordnung nach Anspruch 2, wobei
ein Achsenloch (13) auf dem Auswerfer (10) bereitgestellt ist und das Achsenloch (13) konfiguriert ist, dass der Auswerfer (10) auf dem Plattenelement (30) durch eine Welle (50), die durch das Achsenloch (13) geht, montiert ist.

4. Auswerferanordnung nach Anspruch 2, ferner umfassend eine zweite Feder (61), wobei
die zweite Feder (61) zwischen dem Sperrelement (20) und dem Plattenelement (30) bereitgestellt ist und die zweite Feder (61) konfiguriert ist, eine Kraft auf dem Sperrelement (20) entlang einer Richtung im Wesentlichen senkrecht zur Rotationsebene des Auswerfers (10) bereitzustellen.

5. Auswerferanordnung nach Anspruch 2, wobei
ein Positionierungsabschnitt (14) auf dem Auswerfer (10) bereitgestellt ist und ein positionsgepaarter Abschnitt (32) auf dem Plattenelement (30) bereitgestellt ist und der Positionierungsabschnitt (14) und der positionsgepaarte Abschnitt (32) konfiguriert sind, dass der Positionierungsabschnitt (14) mit dem positionsgepaarten Abschnitt (32), während der Auswerfer (10) auf dem Plattenelement (30) montiert ist, übereinstimmt.

6. Auswerferanordnung nach Anspruch 1, wobei
wenn das Sperrelement (20) durch die Schraube (40) fixiert ist, der Auswerfer (10) in das Plattenelement (30) eingebettet ist.

7. Elektronisches Modul, das mit der Auswerferanordnung nach einem der Ansprüche von 1 bis 6 ausgestattet ist.

8. Elektronische Vorrichtung, enthaltend ein oder mehrere elektronische Module, wobei das eine oder die mehreren elektronischen Module mit der Auswerferanordnung nach einem der Ansprüche von 1 bis 7 ausgestattet sind.

## Revendications

1. Assemblage d'éjecteur pour un attachement de montage d'un appareil électrique, comprenant :
un éjecteur (10) en forme de L, prévu pour tourner autour d'un axe ;
un élément de verrouillage (20), prévu pour se déplacer dans un sens sensiblement perpendiculaire à un plan de rotation de l'éjecteur (10), dans lequel l'éjecteur (10) comprend une portion découpée (12), l'élément de verrouillage (20) comprend une portion d'extrémité (21), et la portion d'extrémité (21) est prévue pour correspondre à la portion découpée (12), le point d'extrémité pouvant être inséré dans la portion découpée pour empêcher toute rotation de l'éjecteur (10) ;
**caractérisé en ce qu'**une portion de trou (22) est prévue sur l'élément de verrouillage (20), la portion de trou (22) étant configurée de sorte que l'élément de verrouillage (20) puisse être fixé par une vis (40) traversant la portion de trou (22), un premier ressort (60) prévu entre l'éjecteur (10) et l'élément de plaque (30), le premier ressort (60) étant configuré pour fournir une force sur l'éjecteur (10) dans un sens de rotation de l'éjecteur (10), de sorte que, lorsque la vis (40) est desserrée, l'élément de verrouillage (20) puisse se déplacer librement afin que la portion d'extrémité (21) de l'élément de verrouillage (20) ne soit pas insérée dans la portion découpée de l'éjecteur (10), l'éjecteur (10) étant capable de tourner de sorte que l'éjecteur (10) éjecte à partir de l'élément de plaque (30) par la force dudit ressort (60).

2. Assemblage d'éjecteur selon la revendication 1, dans lequel
l'assemblage d'éjecteur est prévu pour être assemblé avec un élément de plaque (30) ; et
une portion de correspondance (31) est prévue sur l'élément de plaque (30), et l'élément de verrouillage (20) est prévu pour correspondre à la portion de correspondance (31) de manière à monter l'élément de verrouillage (20) sur l'élément de plaque (30).

3. Assemblage d'éjecteur selon la revendication 2, dans lequel
un trou axial (13) est prévu sur l'éjecteur (10), et le trou axial (13) est configuré de sorte que l'éjecteur (10) soit monté sur l'élément de plaque (30) par un arbre (50) traversant le trou axial (13).

4. Assemblage d'éjecteur selon la revendication 2, comprenant en outre un deuxième ressort (61), dans lequel
le deuxième ressort (61) est prévu entre l'élément de verrouillage (20) et l'élément de plaque (30), et le deuxième ressort (61) est configuré pour fournir une force sur l'élément de verrouillage (20) dans un sens sensiblement perpendiculaire au plan de rotation de l'éjecteur (10).

5. Assemblage d'éjecteur selon la revendication 2, dans lequel
une portion de positionnement (14) est prévue sur l'éjecteur (10), et une portion de positionnement accouplée (32) est prévue sur l'élément de plaque (30), et la portion de positionnement (14) et la portion de positionnement accouplée (32) sont configurées de sorte que la portion de positionnement (14) corresponde à la portion de positionnement accouplée (32) pendant le montage de l'éjecteur (10) sur l'élément de plaque (30) .

6. Assemblage d'éjecteur selon la revendication 1, dans lequel
lorsque l'élément de verrouillage (20) est fixé par la vis (40), l'éjecteur (10) est encastré dans l'élément de plaque (30).

7. Module électronique doté de l'assemblage d'éjecteur selon l'une quelconque des revendications 1 à 6.

8. Appareil électrique comprenant un ou plusieurs modules électroniques, dans lequel lesdits un ou plusieurs modules électroniques sont équipés de l'assemblage d'éjecteur selon l'une quelconque des revendications 1 à 7.
